# EUROPÄISCHE PATENTSCHRIFT

(11) **EP 2 629 079 B1**
(45) Veröffentlichungstag und Bekanntmachung des Hinweises auf die Patenterteilung: **31.03.2021**
(21) Anmeldenummer: 13155360.4
(22) Anmeldetag: 15.02.2013
(51) Int. Cl.: G01N 1/04, G01N 1/28, G01N 1/32, G01N 23/04, H01J 37/00, H01J 37/317

(54) **Verfahren und Vorrichtungen zur Präparation mikroskopischer Proben mit Hilfe von gepulstem Licht**
Method and devices for preparing microscopic samples with the aid of pulsed light
Procédé et dispositifs de préparation d'échantillons microscopiques à l'aide de lumière pulsée

(30) Priorität: 17.02.2012 DE 102012202519
(43) Veröffentlichungstag der Anmeldung: 21.08.2013
(73) Patentinhaber: Carl Zeiss Microscopy GmbH, 07745 Jena (DE)
(72) Erfinder: Stegmann, Heiko, 01099 Dresden (DE)
(74) Vertreter: Carl Zeiss AG - Patentabteilung

(56) Entgegenhaltungen:
- DE-A1-102004 001 173
- DE-A1-102008 052 006
- DE-A1-102010 008 296
- US-A1- 2004 245 466
- US-A1- 2007 272 854
- US-A1- 2008 296 498
- US-A1- 2008 302 770

## Beschreibung

Die Erfindung betrifft Verfahren und Vorrichtungen zur Präparation verschiedenartiger mikroskopischer Proben mit Hilfe von gepulstem Licht.

Die Anwendung moderner Mikroskopiemethoden, wie Transmissionselektronenmikroskopie, Nano-Tomographie oder die Untersuchung der Mikromechanik von Materialien, erfordert oftmals die Präparation von dreidimensionalen Proben mit komplexer Geometrie. Dabei können Materialvolumen von einigen zehn Kubikmikrometern (µm³) bis einigen zehn Kubikmillimetern (mm³) abgetragen werden. Da meist nur eine bestimmte Stelle des Objekts als Probe von Interesse ist, kann nicht eine beliebige Objektregion präpariert werden. Vielmehr kommt es auch darauf an, eine definierte Zielstruktur aus dem Objekt herauszupräparieren, um die gewünschte Probe zu erhalten.

Für die Transmissionselektronenmikroskopie benötigt man sogenannte TEM-Lamellen, die durchlässig für Elektronen sind. Die Länge und Breite der TEM-Lamellen beträgt meist mehrere Mikrometer (µm), ihre Dicke meist weniger als hundert Nanometer (nm). Damit TEM-Lamellen die gewünschte Zielstruktur enthalten, müssen sie in der Regel aus dem vollen Objektmaterial herauspräpariert werden.

Bei Nano-Tomographieverfahren wird die mikroskopische Probe Schicht für Schicht abgetragen, wobei von jeder Schicht ein Bild aufgenommen wird. Die erhaltenden Schichtbilder werden dann zu einer dreidimensionalen Rekonstruktion der Probenstruktur zusammengesetzt. Bei der FIB/REM-Tomographie werden die Schichten mittels fokussiertem Ionenstrahl (FIB) abgetragen, während die Bilder der Schichten mit einem Rasterelektronenmikroskop (REM) aufgenommen werden. Zusätzlich kann die elementare Zusammensetzung der Probe mit Hilfe der energiedispersiven Röntgenspektroskopie (EDS) untersucht werden, indem die elementspezifische Röntgenstrahlung analysiert wird, die beim Auftreffen des Elektronenstrahls auf die Probe vom Probenmaterial ausgesendet wird.

Außerdem besteht die Möglichkeit, Proben mittels wellenlängendispersiver Röntgenspektroskopie (WDS) zu untersuchen.
Bei Proben, die kristalline Strukturen enthalten, kann man mittels EBSD (Electron Backscatter Diffraction) die Verteilung der Kristallorientierungen anhand der zurück gestreuten Elektronen untersuchen. Grundsätzlich muss bei Tomographieproben, insbesondere wenn mit derselben Probe auch EDS- oder WDS-Analysen durchgeführt werden sollen, zunächst das Zielvolumen großräumig frei präpariert werden, damit unerwünschte Abschattungs- und/oder Redepositionseffekte vermieden werden. Für die FIB/REM-Tomographie präpariert man quaderförmige Proben, die an einer der kurzen Seitenflächen mit dem Objekt verbunden bleiben oder alternativ an einer kurzen Seitenflächen und auch an der Grundfläche mit dem Objekt verbunden bleiben. Ähnliche quaderförmige Proben werden für EBSD-Untersuchungen eingesetzt. Bei diesen Proben wird jedoch an einer Seite das gesamte Objektmaterial entfernt, so dass der Probenquader frei in den Raum ragt. Für Untersuchungen mit hochauflösender Röntgen- oder Synchrotronstrahlungstomographie benötigt man nadelförmige Proben. Eine nadelförmige Probe hat im Wesentlichen die Form eines Kegels, wobei der Kegel einen im Verhältnis zur Höhe geringen Durchmesser aufweist und in einer langen Spitze ausläuft. Während die nadelförmige Probe um ihre Längsachse rotiert, werden mit Hilfe von herkömmlicher Röntgenstrahlung oder von Synchrotronstrahlung und geeigneten Detektoren mehrere Bilder aufgenommen, die zu einer dreidimensionalen Darstellung der Probe zusammengesetzt werden können.

Zur In-situ-Untersuchung mikromechanischer Materialeigenschaften benötigt man Proben mit bestimmten geometrischen Formen, wie zum Beispiel stabförmige Proben als Biegebalken, die aus dem vollen Probenmaterial herauspräpariert worden sind. Einseitig eingespannte, freistehende Biegebalken sind beispielsweise geeignet, um mit ihnen die elastischen Eigenschaften eines Materials zu untersuchen. Dazu wird der meist nur wenige 100 Mikrometer große Biegebalken kontrolliert ausgelenkt, was gleichzeitig mit dem REM beobachtet wird. Stabförmige Proben erlauben die Untersuchung des Zug- oder Druckverhaltens eines Materials, indem Veränderungen der mikroskopischen Materialstruktur unter Zug- oder Druckbelastung im REM beobachtet werden.

### Kurze Beschreibung des verwandten Standes der Technik

Es sind Systeme bekannt, bei denen ein Elektronenmikroskop dazu eingesetzt wird, die Probe zu untersuchen, und bei denen der von dem Elektronenmikroskop erzeugte Strahl auch dazu verwendet wird, ein der Probe zugeführtes Prozessgas zu aktivieren, so dass das aktivierte Prozessgas die Probe modifiziert, indem Material abgetragen oder abgeschieden wird.

Ferner sind Systeme bekannt, welche ein Elektronenmikroskop und eine Ionenstrahlsäule umfassen, deren Strahlen gleichzeitig oder alternativ auf einen Ort einer zu modifizierenden Probe gerichtet werden können. Hierbei dient der Ionenstrahl dazu, die Probe zu modifizieren, wobei der Fortgang dieses Prozesses mit dem Elektronenmikroskop beobachtet werden kann. Bei einem solchen System kann zudem Prozessgas zugeführt werden, um die Probe durch das Prozessgas zu modifizieren, das durch den Elektronen- oder Ionenstrahl aktiviert wird. Bei der In-situ-lift-out-Methode wird die zu präparierende Probe mit Hilfe des fokussierten Ionenstrahls herausgeschnitten und anschließend mit einem Mikromanipulator auf einen geeigneten Probenträger übertragen.

Die Bearbeitung mit einem Elektronenstrahl und/oder einem Ionenstrahl und/oder einem aktiviertem Prozessgas ist zwar mit einer hohen Präzision möglich, als Nachteil derartiger Systeme erweist sich jedoch, dass eine solche Bearbeitung sehr langsam und nicht immer erfolgreich ist. Wenn in einem Prozess ein großes Probenvolumen abgetragen werden soll, so wird dafür eine relativ lange Zeit benötigt. Insbesondere die In-situ-lift-out-Methode verlangt vom Bediener außerdem Erfahrung und experimentelles Geschick.

Darüber hinaus ist bekannt, dass Laserbearbeitungssysteme, insbesondere solche, die mit Festkörperlasern arbeiten, dazu geeignet sind, Materialien durch Schneiden, Abtragen, Bohren, Schweißen oder Löten zu bearbeiten. Aus dem Stand der Technik sind außerdem Systeme bekannt, bei denen ein Laserstrahl dazu dient, von einer in der Regel höchstens einige Millimeter großen Probe Material abzutragen. Hierzu wird ein Laserstrahl mit ausreichender Strahlenergie bzw. ausreichender Photonenenergie über eine Abtastvorrichtung bzw. Scanvorrichtung auf zuvor bestimmte Bearbeitungsorte des Objekts gerichtet. Dies erfolgt durch Einstellen von Scanauslenkungen der Scanvorrichtung in Abhängigkeit von Koordinaten der Bearbeitungsorte in einem Koordinatensystem der Scanvorrichtung.

Außerdem sind Bearbeitungssysteme bekannt, die eine Partikelstrahlsäule zur Erzeugung eines gerichteten Partikelstrahls und ein Lasersystem zur Erzeugung eines gerichteten Laserstrahls umfassen. Die Partikelstrahlsäule kann eine Elektronenstrahlsäule und eine Ionenstrahlsäule umfassen, wobei diese Partikelstrahlsäulen beispielsweise auch als ein Elektronenmikroskop oder ein Ionenmikroskop konfiguriert sein können, indem sie einen Sekundärteilchendetektor umfassen. Der Sekundärteilchendetektor kann beispielsweise ein Elektronendetektor oder ein Ionendetektor sein.

Ferner ist ein Laserbearbeitungssystem beschrieben worden, mit dem ein Objekt mit einer vergleichsweise hohen Präzision bearbeitet werden kann, wobei insbesondere ein Wechsel des zu bearbeitenden Objekts zwischen einer Bearbeitung im Laserbearbeitungssystem und einer Bearbeitung oder/und Inspektion in einem weiteren Bearbeitungssystem bzw. Inspektionssystem, wie beispielsweise einem Rasterelektronenmikroskop, möglich ist. Zu diesem Zweck ist ein Objekthalter vorgeschlagen worden, der Markierungen enthält, die die genaue Positionierung und somit das Wiederfinden der zu bearbeitenden Probenstelle erlauben.

Als Stand der Technik sind folgende Dokumente zu betrachten:
DE 10 2008 045 336
US 7442924
DE 10 2010 008 296

### Überblick über die Erfindung

Es ist die Aufgabe der vorliegenden Erfindung Verfahren und Vorrichtungen vorzuschlagen, mit denen in relativ kurzer Zeit Material abgetragen werden kann, um eine Probe zu präparieren.

Das Verfahren gemäß der vorliegenden Erfindung betrifft die Präparation von Proben mittels Lichtpulsen unter Abtrag von Volumen, die größer als 100 µm³ sind und umfasst folgende Schritte: Zunächst wird ein Objekt mit Hilfe eines Rasterelektronenmikroskops (REM) oder eines fokussierten Ionenstrahls (FIB) inspiziert, wobei man ein Bild des Objekts erhält. Dann wird der zu untersuchende Bereich des Objekts anhand des erhaltenen Bildes festgelegt. Anschließend wird der Laser-Bearbeitungsweg anhand des Bildes festgelegt, derart, dass die gewünschte Probe aus dem Material des Objekts heraus präpariert werden kann. Entlang des auf diese Weise festgelegten Laser-Bearbeitungswegs wird das abzutragende Volumen des Objektmaterials entfernt, so dass die gewünschte Zielstruktur in der Probe erhalten bleibt. Anschließend wird die Probe mittels Rasterelektronenmikroskop (REM) oder fokussiertem Ionenstrahl (FIB) inspiziert.

Ein erfindungsgemäßes Verfahren ist beispielsweise geeignet, um TEM-Lamellen zu präparieren. TEM-Lamellen sind Proben, die für die Untersuchung in Transmissionselektronenmikroskopen (TEM) geeignet sind, da die TEM-Lamellen durchlässig für Elektronen sind. Das bedeutet, dass das Probenmaterial der TEM-Lamelle von Elektronen eines im TEM erzeugten Elektronenstrahls durchdrungen werden kann. In der Regel haben TEM-Lamellen im Wesentlichen die Form eines flachen Quaders, wobei die Seiten der Grundfläche meist mehrere Mikrometer lang sind. Die Höhe des Quaders beträgt meist nur einige oder einige zehn Nanometer, so dass die TEM-Lamelle elektronendurchlässig ist.

In dem erfindungsgemäßen Verfahren wird zunächst das zu bearbeitende Objekt, das sich in einer Bearbeitungskammer befindet, beobachtet und ein Bild des Objekts erzeugt. Auf diese Weise können die interessanten Objektstellen, nämlich diejenigen Zielstrukturen, die in der späteren TEM-Lamelle enthalten sein sollen, identifiziert werden. Dementsprechend wird der Bereich des Objekts festgelegt, aus dem die TEM-Lamelle in der Folge heraus präpariert werden soll. Dabei ist üblicherweise eine der Seitenflächen der zu präparierende, quaderförmige TEM-Lamelle in der Draufsicht zu sehen. Der zu präparierende Bereich des Objekts wird festgelegt, indem eine Flächenmarkierung, beispielsweise ein Rechteck, mithilfe einer Betriebssoftware in das Bild des Objekts eingeblendet wird. Die eingeblendete Flächenmarkierung repräsentiert die Ausdehnung einer Vorstufe der TEM-Lamelle in der Draufsicht. Die markierte Fläche der Vorstufe der TEM-Lamelle ist in der Regel größer als die Fläche der TEM-Lamelle, da von der Vorstufe der TEM-Lamelle später so lange Material abgetragen wird, bis die TEM-Lamelle die gewünschten endgültigen Ausmaße hat.

Dann wird mithilfe der Betriebssoftware eine zweite Flächenmarkierung eingeblendet, die die erste Flächenmarkierung ganz einschließt. Das bedeutet also, dass die zweite Flächenmarkierung größer ist als die erste Flächenmarkierung und dass sich die Fläche der ersten Flächenmarkierung vollständig innerhalb der Fläche der zweiten Flächenmarkierung befindet. Die zweite Flächenmarkierung kann beispielsweise ebenfalls ein Rechteck sein. Die Fläche der zweiten Flächenmarkierung abzüglich der Fläche der ersten Flächenmarkierung legt denjenigen Bereich des Objekts fest, in dem Material abgetragen werden soll. Mithilfe der Software kann der Laser-Bearbeitungsweg definiert werden, nämlich indem bestimmt wird, in welcher Weise der Laserstahl über die zu bearbeitenden Objektfläche geführt wird, also zum Beispiel zeilenweise oder kreisförmig. Die Größe der zweiten Flächenmarkierung kann beliebig gewählt werden, je nachdem, wie viel Material entfernt werden soll. In der Regel hat die zweite Flächenmarkierung im Wesentlichen eine ähnliche oder die gleiche Form wie die erste Flächenmarkierung, die die Vorstufe der TEM-Lamelle markiert.

Je nach gewünschter Form der Probe kann die eingeblendete Flächenmarkierung eine beliebige andere geometrische Form haben. Dies ist abhängig von der Form der Grundfläche des zu präparierenden dreidimensionalen Probenkörpers. Um beispielsweise eine zylinderförmige oder kegelförmige Probe zu erhalten, wird eine kreisförmige Flächenmarkierung eingeblendet. Die Positionen der eingeblendeten Flächenmarkierungen können in Koordinaten umgerechnet und gespeichert werden, so dass die markierten Bereiche später wiedergefunden werden können. In einer speziellen Ausführungsform können die vom Benutzer eingeblendeten Flächenmarkierungen gespeichert und später für eine weitere Verwendung wieder aufgerufen werden. Bei einer anderen Ausführungsform ist eine Vielzahl verschiedener Flächenmarkierungen in der Software hinterlegt, so dass der Benutzer eine Auswahl aus vorgefertigten Flächenmarkierungen treffen kann. Beide Ausführungsformen sind geeignet, die Standardisierung und die Automatisierung der Probenpräparation zu ermöglichen und zu erleichtern.

Gemäß der vorliegenden Erfindung wird das abzutragende Probenvolumen nachfolgend entlang des festgelegten Laser-Bearbeitungswegs durch Laserbearbeitung entfernt. Das bedeutet, dass mithilfe von Lichtpulsen ein Volumen abgetragen wird, das größer als 100 µm³ ist. Das abgetragene Volumen wird dabei in eine Materialwolke umgewandelt, die durch Abpumpen aus der Bearbeitungskammer entfernt werden kann. In einer Ausführungsform wird zur Laserbearbeitung vorzugsweise ein gepulster Laser, beispielsweise ein gepulster Festkörperlaser eingesetzt. Festkörperlaser bestehen üblicherweise aus Kristallen oder Gläsern, die mit optisch aktiven Ionen dotiert sind wie beispielsweise YAG (Yttrium-Aluminium-Granat)-Laser oder Nd: YLF (Neodym: Yttrium-Lithiumfluorid)-Laser, und die sich in der Wellenlänge des emittierten, monochromatischen Laserlichts unterscheiden. Alternativ ist es auch denkbar, Laser anderer Bauart für die Laserbearbeitung einzusetzen, beispielsweise Gaslaser, Excimerlaser oder andere für die Materialbearbeitung geeignete Lasertypen. Da Laserlicht kohärent und gerichtet ist, lässt sich das Laserlichtbündel über weite Strecken leiten und stark fokussieren. Dadurch ist es möglich, sehr hohe Leistungsdichten (Leistung pro Fläche) auf der Oberfläche des zu bearbeitenden Objekts zu erzeugen. Zur Materialbearbeitung werden vorzugsweise Laser mit Pulsbetrieb eingesetzt, die durch die Parameter Leistung (Energie pro Zeiteinheit), Pulsdauer und Pulsfrequenz charakterisiert sind.

Eine spezielle Ausführungsform der vorliegenden Erfindung umfasst einen UV-Puls-Laser, vorzugsweise mit der Wellenlänge 355 nm und einer mittleren Pulsdauer vor 10 ns, wobei die Pulsdauer von 5 ns bis 17 ns betragen kann. Je nach Art des abzutragenden Materials können Laser mit unterschiedlichen Wellenlängen eingesetzt werden, d.h. solche mit einer Wellenlänge im Bereich des sichtbaren Licht, aber auch solche mit einer Wellenlänge im Infrarotbereich oder im energiereicheren ultravioletten (UV) Spektralbereich.

Abhängig von der Art des abzutragenden Materials sollten die Parameter Pulsdauer, Pulsleistung, Pulsfrequenz und Wellenlänge abgestimmt sein. Zum Abtragen von Metallen wird in einer speziellen Ausführungsform vorzugsweise ein Laser mit einer Pulsdauer von nur wenigen Picosekunden (ps) oder Femtosekunden (fs) verwendet (Pulsdauer ≤ 20 ps). In einer weiteren Ausführungsform wird ein Nd:VO₄ Festkörperlaser beispielsweise zum Bearbeiten von siliciumhaltigen Materialien wie Halbleitermaterialien oder gehauste Halbleiterbauelemente eingesetzt.

Die Tiefe des Materialabtrags kann sowohl durch die Gesamtdauer, während der das Laserlicht einwirkt, bestimmt werden als auch durch die Variation von Pulsfrequenz und/oder Puls-Energie. Jedes Mal wenn ein Laserpuls auf das zu bearbeitende Objekt auftrifft, wird Objektmaterial einem Phasenübergang in den gasförmigen oder flüssigen Zustand unterworfen oder Material wird in Form von Partikeln abgesprengt, so dass insgesamt Materialvolumen vom Objekt abgetragen wird. Die Pulsfrequenz des Laserpulses sollte so gewählt werden, dass die beim Abtragen entstandene Materialwolke nicht mehr in der Nähe des Objekts vorhanden ist, wenn der nächste Laserpuls auf das Objekt auftrifft. Das Entfernen der Materialwolke kann durch Abpumpen der Bearbeitungskammer beschleunigt werden.

Die Laserbearbeitung kann unter Vakuumbedingungen oder in einer Stickstoff-SauerstoffAtmosphäre erfolgen. Ferner kann in einer speziellen Ausführungsform die Prozesskammer mit einem geeigneten Prozessgas gefüllt werden, so dass zwischen dem Objektmaterial und dem Prozessgas eine chemische Reaktion erfolgt, derart, dass die Materialabtragung beschleunigt wird. Bei der Wahl eines geeigneten Prozessgases sind die vorhandenen Reaktionsbedingungen und die chemische Natur des Objektmaterials zu berücksichtigen.

In einer anderen speziellen Ausführungsform wird mittels eines Gasinjektionssystems gezielt ein geeignetes Gas durch eine Düse mit Überdruck, beispielsweise mit einem Überdruck von 6 bar, auf die abzutragende Objektoberfläche geleitet. Aufgrund der mechanischen Wirkung des Gasstrahls wird die vom Laser abgetragene Materialwolke von der Bearbeitungsstelle entfernt, so dass der Abtragungsprozess beschleunigt wird. Hierfür geeignete Gase sind beispielsweise Luft, Stickstoff oder inerte Gase wie Argon.
Bei der Optimierung der Laserbearbeitungsparameter spielt außerdem die Steilheit der vorderen Pulsflanke eine Rolle. Um Wärmeschäden an der Probe zu minimieren, sollte die Pulsfrequenz hinreichend hoch und die Pulsdauer hinreichend kurz gewählt werden. Um durch Laserbearbeitung bedingte Wärmeschäden völlig auszuschließen, kann eine etwa 10- 15 µm dicke Materialschicht, die die Zielstruktur direkt umgibt, statt durch Lasereinwirkung mit dem fokussierten Ionenstrahl abgetragen werden.

Gemäß einer Ausführungsform kann das Objekt während der Laserbearbeitung mittels REM und/oder FIB beobachtet werden. Gemäß einer anderen beispielhaften Ausführungsform wird das Objekt während der Laserbearbeitung nicht beobachtet.

Gemäß einer Ausführungsform kann das herauspräparierte Objekt, nachdem die Laserbearbeitung abgeschlossen ist, mittels Rasterelektronenmikroskop (REM) oder fokussiertem Ionenstrahl (FIB) inspiziert werden.

Gemäß einer Ausführungsform werden, nachdem das abzutragende Volumen entfernt worden ist, die durch die Laserbearbeitung entstandenen Flächen des Objekts mit dem fokussierten Ionenstrahl (FIB) nachbearbeitet. Dies kann während der Nachbearbeitung im REM beobachtet werden.

Gemäß einer Ausführungsform ist eine erste Bearbeitungskammer die Probenkammer eines Rasterelektronenmikroskops (REM). In einer weiteren Ausführungsform ist die erste Bearbeitungskammer die Probenkammer eines Zweistrahlmikroskops, das eine Elektronensäule und eine dazu geneigt angeordnete Ionenstrahlsäule umfasst, so dass ein Objekt, das sich in der Probenkammer befindet, wahlweise mit einem Elektronenstrahl und/oder einem Ionenstrahl bestrahlt werden kann.

Gemäß einer Ausführungsform ist eine erste Bearbeitungskammer mit einem Rasterelektronenmikroskop (REM) und/oder Ionenmikroskop verbunden. Eine zweite Bearbeitungskammer ist mit einem Laserbearbeitungssystem verbunden. Das Objekt kann von der ersten Bearbeitungskammer in die zweite Bearbeitungskammer, sowie von der zweiten Bearbeitungskammer in die erste Bearbeitungskammer transferiert werden.

In einer speziellen Ausführungsform ist das zu bearbeitende Objekt an einem Objekthalter angebracht. Dieser Objekthalter ist dazu geeignet, das Objekt sowohl in der ersten Bearbeitungskammer als auch in der zweiten Bearbeitungskammer zu halten. Außerdem ermöglicht der Objekthalter den Transfer des Objekts von der ersten Bearbeitungskammer in die zweite Bearbeitungskammer sowie von der zweiten Bearbeitungskammer in die erste Bearbeitungskammer. Das erfindungsgemäße Bearbeitungssystem ist so gestaltet, dass die Koordinaten der gewählten und in das REM-Bild des Objekts eingeblendeten Flächenmarkierungen relativ zum Objektträger gespeichert werden können. Dadurch ist die Repositionierung des Objekts möglich, indem die gespeicherten Koordinaten nach dem Transfer von Objekthalter und Objekt in die Laserbearbeitungskammer wieder aufgerufen werden. Das Bearbeitungssystem weist ferner eine Steuerung auf, die aus einer Rechnereinheit und einer Betriebssoftware besteht. Mittels der bekannten Koordinaten kann die Steuerung den Laserstahl mithilfe von Ablenkspiegeln entlang des vorher festgelegten Laserbearbeitungswegs führen, so dass der Laserstahl genau in der gewünschten Bearbeitungsregion auftrifft und dort Material abträgt. Da der Laserstahl von der Steuerung nur durch den vorher definierten Bearbeitungsbereich geführt wird, ist eine Beobachtung der Probe während der Laserbearbeitung nicht erforderlich. Gleichwohl kann die Probe während der Laserbearbeitung mit einem geeigneten Detektor oder einer geeigneten Kamera beobachtet werden.

Ein erfindungsgemäßes Verfahren ist geeignet, Proben für die Nano-Tomographie herzustellen. Um Abschattung- oder Redepositionseffekte bei der Tomographie zu vermeiden, muss die Umgebung des Zielvolumens zunächst großflächig abgetragen werden. Das erfindungsgemäße Verfahren ist geeignet, verschiedene Probenformen herzustellen. Beispielweise lassen sich freistehende, quaderförmige Proben herstellen, die nur an einer der kurzen Seitenflächen mit dem Objekt verbunden bleiben. Solche Proben werden für die FIB/REM-Tomographie benötigt. Um die quaderförmige Probe zu erhalten, wird zunächst ein Quader herauspräpariert. Dann wird das Objekt gekippt, so dass mit dem Laser das Material unter dem Quader abgetragen werden kann, bis fünf Seiten des Probenquaders frei liegen und der Probenquader nur noch an einer der kurzen Seitenflächen mit dem Objektmaterial verbunden ist. Alternativ kann der beschriebene Unterschnitt, bei dem das Material unterhalb des Quaders entfernt wird, unterbleiben, so dass die Probe sowohl an einer der kurzen Seitenflächen als auch an der Grundfläche mit dem Objektmaterial verbunden bleibt.

Ähnliche quaderförmige Proben werden für EBSD-Untersuchungen benötigt. Bei diesen Proben wird jedoch an einer Seite das gesamte Objektmaterial entfernt, so dass der Probenquader an dieser Seite frei zugänglich ist.

Mit einem erfindungsgemäßen Verfahren können auch nadelförmige Proben hergestellt werden. Dazu wird die erste Flächenmarkierung kreisförmig angelegt, so dass nach dem Abtrag des gewünschten Volumens ein nadelförmiger Probenkörper stehen bleibt. Die Probennadel kann dann durch einen Unterschnitt vom Objekt abgetrennt werden. Probennadeln mit einem Durchmesser bis 60 µm werden für Untersuchungen mittels energiedispersiven Röntgenspektroskopie (EDS) oder wellenlängendispersiver Röntgenspektroskopie (WDS) benötigt. Probennadeln mit einem Durchmesser bis 60 µm werden für hochauflösende Röntgentomographie mit herkömmlichen Röntgenquellen benötigt. Probennadeln mit Durchmessern bis 200 µm werden für die Tomographie mit Synchrotronstrahlung eingesetzt.

In der Medizin finden tomographische Methoden beispielsweise Anwendung bei der Erforschung von Osteoporose. Dazu werden nadelförmige Knochenproben tomographisch untersucht. Die Probenpräparation mit Lasern mit einer Pulsdauer von Femtosekunden (fs) oder Pikosekunden (ps) hat den vorteilhaften Nebeneffekt, dass wasserhaltige Proben - wie beispielsweise Knochenproben - vor der Bearbeitung nicht vollständig dehydriert sein müssen.

Ein anderes erfindungsgemäßes Verfahren ist geeignet, um Proben für die In-situ-Untersuchung von mikromechanischen Materialeigenschaften herzustellen. Diese Proben sind in der Regel stabförmig oder als freistehende Biegebalken ausgebildet.

Bei einem anderen erfindungsgemäßen Verfahren wird mittels eines Mikromanipulators ein Proben-Lift-Out ausgeführt. Das bedeutet, dass die herauspräparierte Probe vom Objektmaterial abgetrennt und mittels des Mikromanipulators auf einen geeigneten Probenträger übertragen wird. Der Probenträger kann dann mit der Probe aus der Vorrichtung entnommen werden.

Bei einem anderen erfindungsgemäßen Verfahren wird die präparierte Probe durch einen Unterschnitt vom Objekt abgetrennt. Dazu wird in der Regel das Zielvolumen soweit abgetragen bis die Probe nur noch an einer räumlich begrenzten Verbindungsstelle mit dem Objekt verbunden ist. Dann kann das Objekt gekippt werden, so dass die zu trennende Verbindungsstelle vom Laserstahl getroffen werden kann. Durch einen Laserschnitt an der Verbindungsstelle wird die Probe vom Objekt abgetrennt. Alternativ kann der Schnitt auch mit einem fokussierten Ionenstrahl ausgeführt werden.

Ein Vorteil der erfindungsgemäßen Verfahren liegt darin, dass Materialvolumen von über 100 µm³ in wenigen Minuten abgetragen werden können. Bei dem erfindungsgemäßen Verfahren kann die Laserbearbeitung insbesondere dann eingesetzt werden kann, wenn Probenvolumen, die größer als 100 µm³ sind, abgetragen werden sollen, wohingegen Objektbereiche, die einen feineren Probenabtrag (d.h. Abtragsvolumen kleiner als 100 µm⁻³) erfordern, mittels fokussiertem Ionenstrahl oder Elektronenstrahl bearbeitet werden können. In einer vorteilhaften Ausführungsform des erfindungsgemäßen Verfahrens erfolgt bei abzutragenden Volumen, die größer oder gleich 100 µm³ sind, das Abtragen des abzutragenden Volumens mit dem Laserstrahl und bei abzutragenden Volumen, die kleiner als 100 µm³ sind, erfolgt das Abtragen des abzutragenden Volumens mit einem fokussierten Teilchenstrahl.

Das bedeutet also, dass erfindungsgemäß eine Grobbearbeitung mit Lichtpulsen und eine Feinbearbeitung mit einem Teilchenstrahl kombiniert werden können. Unter Grobbearbeitung ist zu verstehen, dass Lichtpulse ein Volumen abtragen, das größer oder gleich 100 µm³ ist. Üblicherweise wird dabei das abzutragende Probenmaterial durch die Einwirkung des Laserstahls verdampft oder in Form von Partikeln abgesprengt, so dass das abgetragene Material aus der Bearbeitungskammer abgepumpt werden kann.

Unter Feinbearbeitung ist zu verstehen, dass ein fokussierter Teilchenstrahl, beispielsweise ein Ionenstrahl oder ein Elektronenstrahl, ein Volumen abträgt, das kleiner als 100 µm³ ist. Im Falle der Feinbearbeitung mittels eines Ionenstrahls kann der Materialabtrag durch Sputtern oder durch Sputtern und zusätzliches Einleiten eines geeigneten Prozessgases erfolgen. Im Falle der Feinbearbeitung mittels eines Elektronenstrahls ist es vorteilhaft, wenn der Materialabtrag durch die Einwirkung des Elektronenstrahls und eines geeigneten Prozessgases erfolgt, derart, dass ein elektronenstrahlinduzierter, gas-chemischer Prozess abläuft. Auch das mittels Feinbearbeitung abgetragene Material wird vorteilhafterweise aus der Bearbeitungskammer abgepumpt.
Somit sind die erfindungsgemäßen Verfahren dazu geeignet, in kurzer Zeit verschiedenartige mikroskopische Proben zu präparieren. Ein weiterer Vorteil der vorliegenden Erfindung ist, dass die Implantation von Ionen, die bei einem großvolumigen Probenabtrag mittels fokussiertem Ionenstrahl auftritt, vermieden wird. Ebenfalls vermieden werden mechanische Probenschädigungen oder chemische Veränderungen, die bei herkömmlichen Methoden aufgrund mechanischer Bearbeitung oder aufgrund der Wechselwirkung mit Prozessgasen auftreten können.

Es hat sich als vorteilhaft erwiesen, dass das zu bearbeitenden Objekt, aus dem die Probe herauspräpariert werden soll, auf einem Probentisch in der Bearbeitungskammer gehalten wird. Erfindungsgemäß wird das abzutragenden Volumen von mehr als 100 µm³ entfernt und verworfen, wohingegen das interessierende Detail, das als Probe präpariert worden ist, weiterhin mit dem Objekt verbunden bleibt. Das Objekt mitsamt präparierter Probe kann somit in bequemer Weise mit REM und/oder FIB inspiziert werden.

Eine Vorrichtung gemäß der vorliegenden Erfindung ist geeignet zur Präparation von Proben mittels Lichtpulsen unter Abtrag von Volumen, die größer als 100 µm³ sind. Die Vorrichtung umfasst ein Ionenmikroskop zum Erzeugen eines fokussierten Ionenstrahls (FIB) und/oder ein Rasterelektronenmikroskop und weiterhin ein Lasersystem zur Laserbearbeitung. Die erfindungsgemäße Vorrichtung ist geeignet, mittels des fokussierten Ionenstrahls und/oder des REM ein Bild des Objekts aufzunehmen, anhand dessen ein Laser-Bearbeitungsweg festgelegt werden kann. Das Lasersystem der Vorrichtung ist so gestaltet, dass entlang des festgelegten Laser-Bearbeitungswegs die Probe aus dem Probenmaterial herauspräpariert werden kann. Mithilfe des Rasterelektronenmikroskops (REM) und/oder des fokussierten Ionenstrahls (FIB) der Vorrichtung kann die präparierte Probe inspiziert werden.

Gemäß einer Ausführungsform ist eine erste Bearbeitungskammer die Probenkammer eines Rasterelektronenmikroskops (REM). In einer weiteren Ausführungsform ist die erste Bearbeitungskammer die Probenkammer eines Zweistrahl-Mikroskops, das ein Rasterelektronenmikroskop (REM) sowie eine Ionenstrahlsäule umfasst, so dass ein Objekt, das sich in der Probenkammer befindet, wahlweise mit einem Elektronenstrahl und/oder einem Ionenstrahl bestrahlt werden kann.

Gemäß einer Ausführungsform der erfindungsgemäßen Vorrichtung ist eine erste Bearbeitungskammer Bestandteil eines Rasterelektronenmikroskops oder eines Zweistrahl-Mikroskops, wohingegen eine zweite Bearbeitungskammer mit einem Lasersystem zur Laserbearbeitung verbunden ist. Die Vorrichtung ist so gestaltet, dass das Objekt von der ersten Bearbeitungskammer in die zweite Bearbeitungskammer transferiert werden kann. Außerdem kann das Objekt von der zweiten Bearbeitungskammer in die erste Bearbeitungskammer transferiert werden.

Gemäß einer beispielhaften Ausführungsform umfasst das Lasersystem zur Laserbearbeitung einen UV-Puls-Laser, der beispielsweise mit einer Wellenlänge von 355 nm und einer mittleren Pulsdauer von 10 ns arbeiten kann.

Gemäß einer speziellen Ausführungsform umfasst die Vorrichtung einen Mikromanipulator, mit dem ein Proben-Lift-Out ausgeführt werden kann sowie einen geeigneten Probenträger. Beim Proben-Lift-Out wird die herauspräparierte Probe vom Objektmaterial abgetrennt und mittels des Mikromanipulators auf den Probenträger übertragen. Probenträger und Vorrichtung sind derart gestaltet, dass der Probenträger aus der Vorrichtung entnommen werden kann.

### Ausführungsbeispiele

Ausführungsbeispiele der Erfindung werden nachfolgend anhand von Figuren erläutert.
- Fig. 1: zeigt ein Flussdiagramm eines erfindungsgemäßen Verfahrens,
- Fig. 2: zeigt beispielhaft die Präparation einer TEM-Lamelle, wobei
Fig. 2a eine Draufsicht des Objekts zeigt,
Fig. 2b eine schematische Darstellung der Flächenmarkierung zur Festlegung des Laser-Bearbeitungswegs zeigt und
Fig. 2c eine schematische Darstellung der TEM-Lamellen-Vorstufe nach dem Entfernen des Materialvolumens durch Laser-Abtrag.
- Fig. 3: zeigt verschiedene Probenformen, wobei
Fig. 3a eine FIB/TEM-Tomographie-Probe zeigt,
Fig. 3b eine EBSD-Probe zeigt,
Fig. 3c eine Probe für die Röntgen- oder Synchrotron-Tomographie zeigt und
Fig. 3d einen Biegebalken für Materialuntersuchung zeigt.
- Fig. 4: zeigt schematisch eine beispielhafte Ausführungsform der erfindungsgemäßen Vorrichtung.

Nachfolgend werden Ausführungsformen der Erfindung im Zusammenhang mit den Figuren erläutert. Hierbei werden Komponenten, die sich hinsichtlich ihrer Struktur und Funktion entsprechen, mit Bezugszeichen versehen, die gleiche Ziffern aufweisen, zur Unterscheidung jedoch mit einem zusätzlichen Buchstaben ergänzt sind. Zur Erläuterung der Komponenten wird deshalb auch auf die gesamte jeweils vorangehende und nachfolgende Beschreibung Bezug genommen.

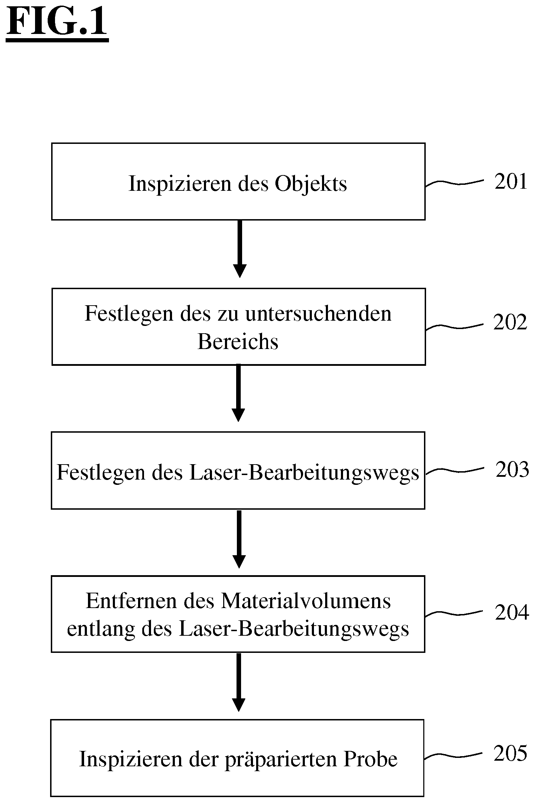

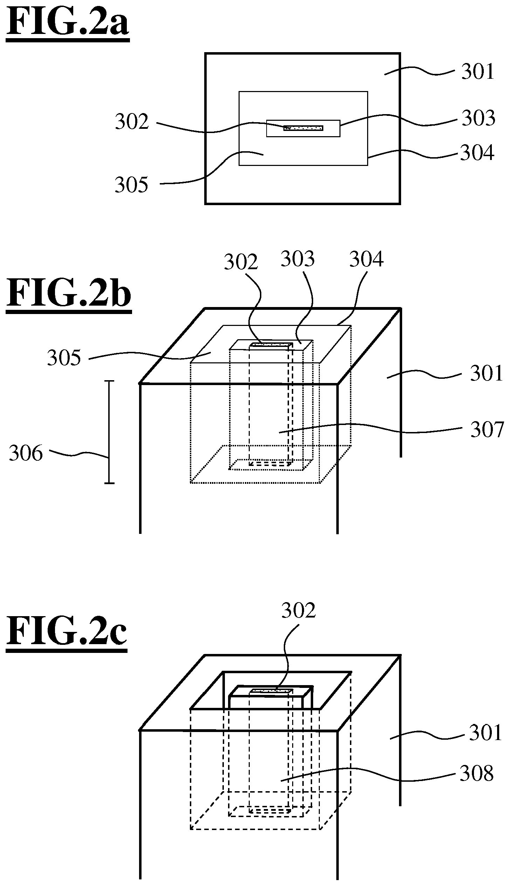

Fig. 1 zeigt ein Flussdiagramm eines erfindungsgemäßen Verfahrens. Das Objekt, aus dem die Probe herauspräpariert werden soll, befindet sich in einer Bearbeitungskammer eines erfindungsgemäßen Bearbeitungssystems. In Schritt 201 wird das Objekt inspiziert. Dies kann mithilfe eines Elektronenmikroskops oder eines fokussierten Ionenstrahls erfolgen oder mit einer Kombination aus Elektronenmikroskop und fokussiertem Ionenstrahl. In jedem Fall wird ein Bild aufgenommen, das für eine mögliche spätere Verwendung gespeichert werden kann. In Schritt 202 wird anhand des im Schritt 201 aufgenommenen Bildes der zu untersuchende Bereich festgelegt. Gewöhnlich sind nur bestimmte Stellen des Objekts von Interesse, da eine ganz bestimmte dreidimensionale Zielstruktur in der zu präparierenden Probe enthalten sein soll. Dementsprechend wird der zu untersuchende Bereich ausgewählt und im Bild mithilfe einer Software markiert (siehe Fig. 2a und 2b).
In Schritt 203 wird eine zweite Flächenmarkierung in das Bild eingefügt. Die zweite Flächenmarkierung ist größer als die erste Flächenmarkierung, so dass sich die Fläche der ersten Flächenmarkierung vollständig in der Fläche der zweiten Flächenmarkierung befindet. Diejenige Fläche, die in der zweiten Flächenmarkierung liegt, jedoch nicht in der ersten Flächenmarkierung, entspricht dem Bereich des Objekts, in dem Objektmaterial durch die Laserbearbeitung abgetragen werden soll. Mithilfe der Software kann der Laser-Bearbeitungsweg definiert werden, entlang dessen der Laserstahl über den zu bearbeitenden Objektbereich geführt wird. In Schritt 204 wird entlang des Laser-Bearbeitungswegs das Material abgetragen. Der Materialabtrag geschieht mithilfe von Laserablation. In Schritt 205 wird die präparierte Probe inspiziert. Falls erforderlich, kann sich eine Nachbearbeitung mit einem fokussierten Ionenstrahl (zum Beispiel Polieren) oder mittels prozessgasgestütztem Elektronenätzen anschließen. Dies ist insbesondere dann sinnvoll, wenn durch nachträgliche Bearbeitung mit dem fokussierten Ionenstrahl Randbereiche der präparierten Probe, die zuvor durch den Laserstahl geschädigt worden sind, nachgearbeitet, insbesondere abgetragen werden.

Figuren 2a bis 2c zeigen beispielhaft Schritte bei der Präparation einer TEM-Lamelle. Fig 2a zeigt eine Draufsicht des Objekts 301, Fig. 2b eine perspektivische Darstellung des Objekts 301. Vom Objekt 301 wird ein Bild aufgenommen, das das Objekt in der Draufsicht zeigt.

Dabei kann die Zielstruktur 302, die später in der Probe enthalten sein soll, identifiziert werden. Mit Hilfe einer Betriebssoftware ist in das Bild des Objekts 301 eine erste Flächenmarkierung 303 eingeblendet worden, die die Vorstufe der TEM-Lamelle repräsentiert. Die Vorstufe der TEM-Lamelle ist größer als die Zielstruktur 302, da von der Vorstufe später so lange Material abgetragen wird, bis die TEM-Lamelle die endgültigen Ausmaße hat. Mit der Software wird eine zweite Flächenmarkierung 304 eingeblendet, die die erste Flächenmarkierung 304 beinhaltet. Die Fläche der zweiten Flächenmarkierung 304 abzüglich der Fläche der ersten Flächenmarkierung 303 repräsentiert die Grundfläche des anzutragenden Volumenkörpers 305 und definiert somit den Bereich, in der der Laserbearbeitungsweg liegt. Der genaue Verlauf des Laser-Bearbeitungswegs wird mithilfe der Software festgelegt. Bedingt durch den kleinstmöglichen Fokus des Laserstrahls haben die eingeblendeten Flächenmarkierungen in der Regel eine Mindestbreite. Die Software kann die Mindestbreite bei der Einblendung vorgeben. In einer alternativen Ausführungsform kann die Software für die jeweils vom Benutzer eingegebenen Bearbeitungsbreite vorschlagen, ob diese gewünschte Bearbeitungsbreite mit dem Laserstahl oder mit einem fokussierten Teilchenstrahl bearbeitet werden kann.

Entlang des Laserbearbeitungswegs wird mit dem Laser das abzutragende Volumen 307 entfernt, wobei das durch die Lichtpulse abzutragende Volumen 307 größer als 100 µm³ ist und in eine Materialwolke umgewandelt wird. Das abzutragende Volumen 307 sich ergibt aus der Grundfläche des abzutragenden Volumens 305 und der Abtragungstiefe 306. Die Abtragungstiefe 306 wird in der Regel von der Gesamtbearbeitungsdauer, während der das Laserlicht einwirkt, bestimmt. In einer Ausführungsform kann der Benutzer die gewünschte Abtragungstiefe 306 in der Software auswählen, da in der Software eine Tabelle hinterlegt ist, die die Abtragungsraten in Abhängigkeit vom zu bearbeitenden Material und der Größe der markierten Bearbeitungsfläche enthält. Anhand der hinterlegten Tabelle kann die Steuerung die für eine gewünschte Abtragungstiefe 306 erforderliche Gesamtbearbeitungsdauer ermitteln. Gemäß einer anderen Ausführungsform kann der Benutzer zusätzlich weitere Abtragungsraten für beliebige Materialien selbst ermitteln und in einer in der Software hinterlegten Tabelle für eine spätere Verwendung speichern.

Fig. 2c zeigt das bearbeitete Objekt 301, bei dem das abzutragende Volumen vollständig entfernt worden ist, so dass die Vorstufe der TEM-Lamelle 308 frei präpariert ist.

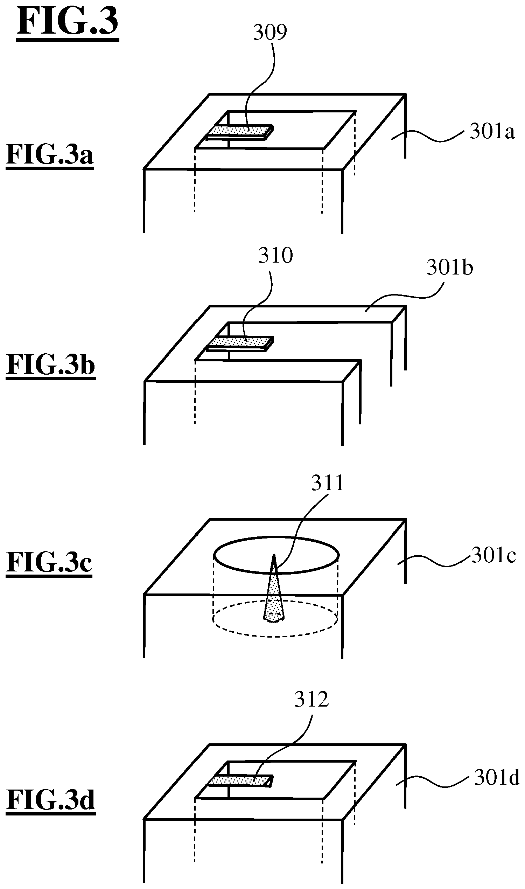

Fig. 3 zeigt beispielhaft verschiedene Probentypen, die mit dem erfindungsgemäßen Verfahren hergestellt werden können. In Fig. 3a ist eine quaderförmige FIB/REM-Tomographie-Probe 309 zu sehen, die aus dem Material eines Objekts 301' herauspräpariert worden ist. Fig. 3b zeigt eine EBSD-Probe 310, die für EBSD-Analysen geeignet ist. Die Probe ist quaderförmig aus dem Material eines Objekts 301' herauspräpariert worden. Im Unterschied zu FIB/REM-Tomographie-Proben 309 ist das Material an einer Seite des Objekts 301' vollständig entfernt worden, so dass die EBSD-Probe 310 von dieser Seite frei zugänglich ist. Fig. 3c zeigt eine Röntgen-/Synchrotrontomographie-Probe 311, die nadelförmig ausgebildet ist und für die Röntgentomographie und/oder Synchrotrontomographie geeignet ist. Fig. 3d zeigt einen Biegebalken 312 für die mikromechanische Materialuntersuchung.

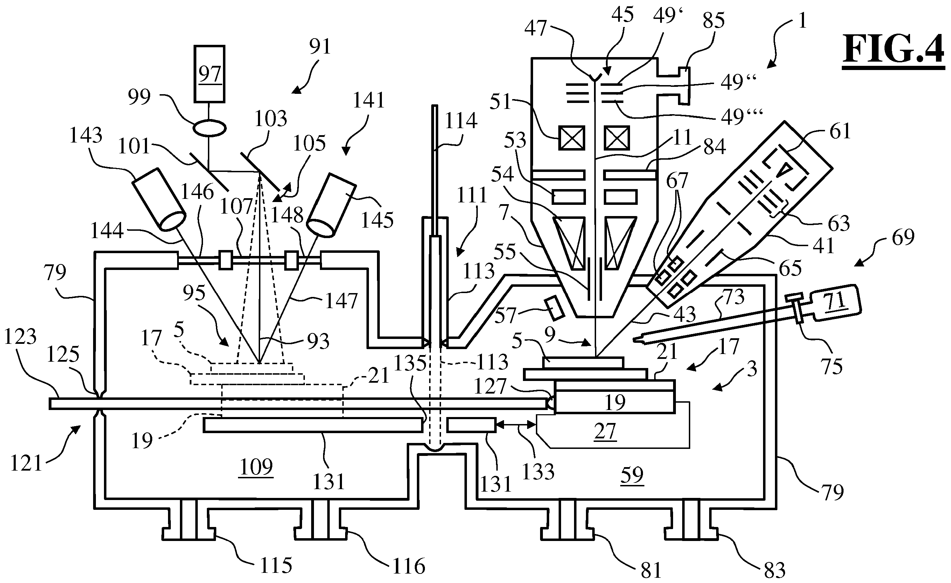

Fig. 4 ist eine schematische Darstellung einer beispielhaften Ausführungsform der erfindungsgemäßen Vorrichtung zur Präparation von Proben. Dargestellt ist ein Bearbeitungssystems 1. Das Bearbeitungssystem 1 umfasst zwei Partikelstrahlsäulen, nämlich die Elektronenstrahlsäule 7 zur Erzeugung des Elektronenstrahls 11 und eine Ionenstrahlsäule 41 zur Erzeugung eines Ionenstrahls 43, welcher wie der Elektronenstrahl 11 auf den Bearbeitungsort für die Inspektion 9 gerichtet ist. Die Elektronenstrahlsäule 7 umfasst eine Elektronenquelle 45 mit einer Kathode 47, einer Suppressorelektrode 49', einer Extraktorelektrode 49" und einer Anode 49"', ein Kondensorlinsensystem 51 zur Erzeugung des Strahls 11, einen beispielsweise innerhalb der Säule 7 angeordneten Sekundärelektronendetektor 53 und eine Objektivlinse 54, um den Elektronenstrahl 11 an dem Bearbeitungsort für die Inspektion 9 zu fokussieren. Strahlablenker des Elektronenstrahls 55 sind vorgesehen, um den Auftreffort des Elektronenstrahls 11 auf die Probe 5 zu variieren und beispielsweise einen Bereich der Probenoberfläche abzurastern und dabei erzeugte oder freigesetzte Teilchen, im vorliegenden Ausführungsbeispiel Sekundärelektronen, mit dem Detektor 53 zu detektieren, um ein elektronenmikroskopisches Bild der Probe 5 in dem abgerasterten Bereich an dem Bearbeitungsort für die Inspektion 9 zu gewinnen. Alternativ oder zusätzlich können auch andere Wechselwirkungsprodukte, wie zum Beispiel zurück gestreute Primärelektronen, mittels geeigneter Detektoren detektiert werden. Außer dem innerhalb der Elektronenstrahlsäule 7 angeordneten Detektor 53 können beispielsweise zusätzlich oder alternativ hierzu ein oder mehrere Sekundärteilchendetektoren, wie beispielsweise ein Elektronendetektor 57 oder ein Ionendetektor, neben der Säule 7 innerhalb einer ersten Vakuumkammer 59 nahe dem Bearbeitungsort für die Inspektion 9 vorgesehen sein, um ebenfalls Sekundärteilchen zu detektieren.

Die Ionenstrahlsäule 41 umfasst eine Ionenquelle 61 und Elektroden 63 zur Formung und Beschleunigung des Ionenstrahls 43 sowie Strahlablenker des Ionenstrahls 65 und Fokussierspulen oder Fokussierelektroden 67, um ebenfalls den Ionenstrahl 43 an dem Bearbeitungsort für die Inspektion 9 zu fokussieren und dort über einen Bereich der Probe 5 zu rastern.

Ein Gaszuführungssystem 69 umfasst ein Reservoir 71 für ein Prozessgas, welches über eine Leitung 73, die nahe dem Bearbeitungsort endet, beispielsweise durch ein Ventil 75 gesteuert, der Probe 5 zugeführt werden kann. Das Prozessgas kann durch den Ionenstrahl oder den Elektronenstrahl aktiviert werden, um an der Probe 5 Material abzutragen oder dort Material zu deponieren. Der Fortgang dieser Bearbeitung kann mithilfe der Elektronenstrahlsäule 7 und einem angeschlossenen Detektor 53, 57 beobachtet werden. Ein Materialabtrag kann auch alleine durch Bearbeitung mit dem Ionenstrahl und ohne die Zuführung von Prozessgas erreicht werden.

Die erste Vakuumkammer 59 ist durch eine Kammerwand 79 begrenzt, die einen mit einer Vakuumpumpe verbundenen ersten Pumpstutzen 81 aufweist und der über einen Belüftungsstutzen 83 belüftet werden kann. Um die Elektronenquelle 45 permanent unter ausreichend gutem Vakuum halten zu können, auch wenn in der ersten Vakuumkammer 59 Prozessgas eingeleitet wird, umfasst die Elektronenstrahlsäule 7 eine Druckblende 84 und einen zweiten Pumpstutzen 85, um den Bereich der Elektronenquelle 45 durch eine separate Vakuumpumpe abzupumpen.

Das Bearbeitungssystem 1 umfasst ferner ein Lasersystem 91, welches dazu konfiguriert ist, einen Laserstrahl 93 auf einen zweiten Bearbeitungsort 95 zu richten. Hierzu umfasst das Lasersystem 91 einen Laser 97 und eine Kollimationsoptik 99, um den Laserstrahl 93 zu formen. Der Laserstrahl 93 wird über einen oder mehrere Spiegel 101 oder Lichtleiter zu einem Ort nahe der Kammerwand 79 geleitet und trifft dort auf einen Schwenkspiegel 103, der den Strahl hin zu dem Bearbeitungsort für die Laserbearbeitung 95 richtet und dabei, wie durch einen Pfeil 105 angedeutet, schwenkbar ist, so dass der Laserstrahl 93 einen Bereich auf einer an dem Bearbeitungsort für die Laserbearbeitung 95 angeordneten Probe abrastern kann, wenn diese an dem Bearbeitungsort für die Laserbearbeitung 95 angeordnet ist.

Hierbei tritt der Laserstrahl 93 über ein Eintrittsfenster 107 in eine Vakuumkammer des Lasersystems 109 ein, die ebenfalls durch die Kammerwand 79 begrenzt ist, von der ersten Vakuumkammer 59 allerdings durch eine zu öffnende Tür 111 separierbar ist. Figur 4 zeigt eine Verschlussplatte 113 der Tür 111 in durchgezogener Linie in geöffnetem Zustand der Tür und in unterbrochener Linie in geschlossenem Zustand der Tür 111. Eine Aktuatorstange 114 der Tür dient dazu, die Verschlussplatte 113 zu verlagern, um die Tür von ihrem geöffneten Zustand in ihren geschlossenen Zustand überzuführen. Die Tür 111 kann hierbei als Vakuumverschluss ausgebildet sein, indem sie gegenüber der Kammerwand 79 abgedichtet ist, um in der ersten Vakuumkammer 59 und der Vakuumkammer des Lasersystems 109 unterschiedliche Vakuumdrücke aufrechtzuerhalten. Hierbei wird die Vakuumkammer des Lasersystems 109 über einen mit einer Vakuumpumpe verbundenen Pumpstutzen des Lasersystems 115 evakuiert und kann über einen Belüftungsstutzen des Lasersystems 116 belüftet werden.

Die Probe 5 kann durch eine Transportvorrichtung 121 zwischen dem Bearbeitungsort für die Inspektion 9 und dem Bearbeitungsort für die Laserbearbeitung 95 hin und her transportiert werden. Hierzu umfasst die Transportvorrichtung 121 ein Gestänge 123, welches durch eine Vakuumdurchführung 125 in den Vakuumraum 109 eintritt. Die Vakuumdurchführung 125 ist somit näher an dem Bearbeitungsort für die Laserbearbeitung 95 angeordnet als an dem Bearbeitungsort für die Inspektion 9. An einem Ende des Gestänges 123 ist eine Kupplung 127 vorgesehen, welche an den Sockel 19 des Positioniertisches 17 gekoppelt ist.

In Figur 4 befindet sich der Positioniertisch 17 in einer solchen Position, dass die Probe 5 an dem Bearbeitungsort für die Inspektion 9 zur Inspektion oder Bearbeitung mit dem Elektronenstrahl 11 bzw. dem Ionenstrahl 43 angeordnet ist. In gestrichelter Darstellung ist der Positioniertisch 17 in Figur 4 in einer solchen Position dargestellt, dass die Probe 5 an dem Bearbeitungsort für die Laserbearbeitung 95 zur Bearbeitung durch den Laserstrahl 93 angeordnet ist. Durch die Transportvorrichtung 21 kann der Positioniertisch 17 mitsamt der Probe 5 zwischen diesen beiden Positionen hin und her bewegt werden. Hierzu umfasst die Transportvorrichtung 121 eine Schiene 131, um den Positioniertisch 17 während des Transports und während seiner Positionierung an dem Bearbeitungsort für die Laserbearbeitung 95 gegen seine Schwerkraft abzustützen. Wenn der Tisch in seiner Position an dem Bearbeitungsort für die Inspektion 9 angeordnet ist, wird der Tisch, wie vorangehend beschrieben, durch den Träger 27 der Probenhalterung 3 getragen.

Zwischen dem Träger 27 und der Schiene 131 ist in der Darstellung der Figur 4 ein Abstand 133 vorgesehen, um das Schwenken des Trägers 27 um eine Achse senkrecht zur Zeichnungsebene ohne Kollision mit der Schiene 131 zu ermöglichen, nachdem das Gestänge 123 von der Kupplung 127 gelöst und etwas (in Figur 4 nach links) zurückgezogen wurde. Es ist jedoch möglich, den Sockel 19 der Positioniervorrichtung 17 über den Abstand hinweg auf die Schiene 131 zu ziehen. Die Schiene 131 weist ferner eine Unterbrechung 135 auf, welche die Platte 113 durchsetzt, wenn die Tür 111 in ihrer geschlossenen Position ist. Die Tür 111 kann dann geschlossen werden, wenn die Transportvorrichtung 123 die Positioniervorrichtung 17 in die Position an dem Bearbeitungsort für die Laserbearbeitung 95 gezogen hat oder nur das Gestänge 123 in Figur 4 vollständig nach links zurückgezogen ist, wobei die Positioniervorrichtung in der Position an dem Bearbeitungsort für die Inspektion 9 verbleibt.

An dem Bearbeitungsort für die Laserbearbeitung 95 findet die Bearbeitung der Probe 5 mit dem Laserstrahl 93 statt, wobei von der Probe 5 abdampfende oder sich von dieser ablösende Partikel das Vakuum in der Vakuumkammer des Lasersystems 109 verschlechtern. Dann verhindert die geschlossene Tür 111 eine Verschlechterung des Vakuums in der ersten Vakuumkammer 59, sowie eine nachhaltige Kontamination der ersten Vakuumkammer 59. Dadurch werden unter anderem die Elektronenstrahlsäule 7 und die Ionenstrahlsäule 41 geschützt.

Die Bearbeitung der Probe 5 durch den Laserstrahl 93 wird überwacht durch eine Endpunktdetektionsvorrichtung 141, die beispielsweise eine Lichtquelle 143 zur Erzeugung eines Lichtstrahls 144 und einen Lichtdetektor 145 umfasst. Der Lichtstrahl 144 tritt durch ein erstes Fenster 146 in die Vakuumkammer des Lasersystems 109 ein und ist auf den Bearbeitungsort für die Laserbearbeitung 95 gerichtet. Der Lichtdetektor 145 empfängt einen von dem Bearbeitungsort für die Laserbearbeitung 95 reflektierten Lichtstrahl 147 durch ein zweites Fenster 148. Durch Analyse des von dem Lichtdetektor 145 empfangenen Lichts kann auf einen Zustand der Probe 5, die durch den Laserstahl 93 bearbeitet wird, geschlossen werden und insbesondere kann diese Bearbeitung auch beendet werden. Nach Beendigung dieser Bearbeitung durch den Laserstrahl wird die Türe 111 geöffnet und die Transportvorrichtung 121 transportiert die Probe 5 mit samt dem Positioniertisch 17 hin zu dem Bearbeitungsort für die Inspektion 9, wo dann mit dem Ionenstrahl 43 und einem zugeführten Prozessgas eine weitere Bearbeitung der Probe 5 durchgeführt wird, die mit Hilfe der Elektronenstrahlsäule 7 mit angeschlossenem Detektor 53, 57 beobachtet werden kann.

### Bezugszeichenliste

- 1: Bearbeitungssystem
- 5: Probe
- 7: Elektronenstrahlsäule
- 9: Bearbeitungsort für die Inspektion
- 11: Elektronenstrahl
- 17: Positioniertisch
- 19: Sockel
- 21: Transportvorrichtung
- 27: Träger
- 41: Ionenstrahlsäule
- 43: Ionenstrahl
- 45: Elektronenquelle
- 47: Kathode
- 49': Suppressorelektrode
- 49": Extraktorelektrode
- 49''': Anode
- 51: Kondensorlinsensystem
- 53: Detektor
- 54: Objektivlinse
- 55: Strahlablenker des Elektronenstrahls
- 57: Elektronendetektor
- 59: erste Vakuumkammer
- 61: Ionenquelle
- 63: Elektroden
- 65: Strahlablenker des Ionenstrahls
- 67: Fokussierelektroden
- 69: Gaszuführungssystem
- 71: Reservoir
- 73: Leitung
- 75: Ventil
- 79: Kammerwand
- 81: erster Pumpstutzen
- 83: Belüftungsstutzen
- 84: Druckblende
- 85: zweiter Pumpstutzen
- 91: Lasersystem
- 93: Laserstrahl
- 95: Bearbeitungsort für die Laserbearbeitung
- 97: Laser
- 99: Kollimationsoptik
- 101: Spiegel
- 103: Schwenkspiegel
- 105: Pfeil
- 107: Eintrittsfenster
- 109: Vakuumkammer des Lasersystems
- 111: Tür
- 113: Verschlussplatte
- 114: Aktuatorstange
- 115: Pumpstutzen des Lasersystems
- 116: Belüftungsstutzen
- 121: Transportvorrichtung
- 123: Gestänge
- 125: Vakuumdurchführung
- 127: Kupplung
- 131: Schiene
- 133: Abstand
- 135: Unterbrechung
- 141: Endpunktdetektionsvorrichtung
- 143: Lichtquelle
- 144: Lichtstrahl
- 145: Lichtdetektor
- 146: erstes Fenster
- 147: reflektierter Lichtstrahl
- 148: zweites Fenster

- 201: Schritt: Inspizieren des Objekts
- 202: Schritt: Festlegen des zu untersuchenden Bereichs
- 203: Schritt: Festlegen des Laser-Bearbeitungswegs
- 204: Schritt: Entfernen des Materialvolumens entlang des Laser-Bearbeitungswegs
- 205: Schritt: Inspizieren der präparierten Probe

- 301: Objekt
- 301a: Objekt
- 301b: Objekt
- 301c: Objekt
- 301d: Objekt
- 302: Zielstruktur
- 303: Erste Flächenmarkierung
- 304: Zweite Flächenmarkierung
- 305: Grundfläche des abzutragenden Volumenkörpers
- 306: Abtragungstiefe
- 307: Abzutragendes Volumen

- 308: TEM-Lamelle
- 309: FIB/REM-Tomographie-Probe
- 310: EBSD-Probe
- 311: Röntgentomographie- /Synchrotrontomographie-Probe
- 312: Biegebalken

## Patentansprüche

1. Verfahren zur Probenpräparation mittels Lichtpulsen unter Abtrag von Volumen, das folgende Schritte umfasst:
- Inspizieren eines Objekts (301) mittels eines Rasterelektronenmikroskops (REM) oder eines fokussierten Ionenstrahls (FIB), wobei ein Bild des Objekts (301) aufgenommen wird,
- Festlegen eines zu untersuchenden Bereichs des Objekts (301),
- Festlegen eines Laser-Bearbeitungsweges anhand des Bilds des Objekts (301) derart, dass eine Probe (308, 309, 310, 311, 312) aus dem Objekt (301) herauspräpariert werden kann, wobei eine erste Flächenmarkierung (303) und eine zweite Flächenmarkierung (304) in das Bild des Objekts eingefügt werden, wobei die erste Flächenmarkierung (303) eine Vorstufe der zu präparierenden Probe (302) repräsentiert; und die Fläche der zweiten Flächenmarkierung (304) die Fläche der ersten Flächenmarkierung (303) beinhaltet; und die Fläche der zweiten Flächenmarkierung abzüglich der Fläche der ersten Flächenmarkierung den Bereich (305) definiert, in dem der Laser-Bearbeitungsweg liegt;
- Entfernen eines abzutragenden Volumens (307) durch Laserbearbeitung entlang des festgelegten Laser-Bearbeitungswegs, wobei das durch die Lichtpulse abzutragende Volumen größer als 100 µm³ ist und in eine Materialwolke umgewandelt wird und
- Inspizieren des Objekts (301) mittels Rasterelektronenmikroskop (REM) oder fokussiertem Ionenstrahl (43, FIB).

2. Verfahren nach Anspruch 1, wobei bei abzutragenden Volumen (307), die größer oder gleich 100 µm³ sind, das Abtragen mit dem Laserstahl erfolgt und bei abzutragenden Volumen (307), die kleiner als 100 µm³ sind, das Abtragen mit einem fokussierten Teilchenstrahl (41) erfolgt.

3. Verfahren nach Anspruch 1 oder 2, wobei das Objekt (301) während der Laserbearbeitung nicht beobachtet wird.

4. Verfahren nach einem der Ansprüche 1 - 3, wobei nach dem Entfernen des abzutragenden Volumens die durch die Laserbearbeitung entstandenen Flächen des Objekts (301) mit dem fokussierten Ionenstrahl (FIB) nachbearbeitet werden.

5. Verfahren nach einem der Ansprüche 1 - 4, wobei das Objekt (301) von einer ersten Bearbeitungskammer, die Bestandteil eines Rasterelektronenmikroskops (REM) und/oder Bestandteil eines Ionenmikroskops ist, in eine zweite Bearbeitungskammer, die Bestandteil eines Laserbearbeitungssystems ist, transferiert wird, und nachfolgend von der zweiten Bearbeitungskammer in die erste Bearbeitungskammer transferiert wird.

6. Verfahren nach einem der Ansprüche 1 - 5, wobei die Laserbearbeitung mit einem Puls-Laser ausgeführt wird.

7. Verfahren nach einem der Ansprüche 1 - 6, wobei als zu präparierende Probe eine TEM-Lamelle (308) hergestellt wird.

8. Verfahren nach einem der Ansprüche 1 - 6, wobei als zu präparierende Probe eine Probe für die FIB/REM-Tomographie (309) hergestellt wird.

9. Verfahren nach einem der Ansprüche 1 - 6, wobei als zu präparierende Probe eine Probe für die FIB/REM-Tomographie (309) hergestellt und die Probe auch für eine EDS- und/oder WDS-Analyse verwendet wird.

10. Verfahren nach einem der Ansprüche 1 - 6, wobei als zu präparierende Probe eine Probe für die EBSD-Analyse (310) hergestellt wird.

11. Verfahren nach einem der Ansprüche 1 - 6, wobei als zu präparierende Probe eine Probe (311) für die hochauflösende Röntgentomographie mit herkömmlichen Röntgenquellen hergestellt wird.

12. Verfahren nach einem der Ansprüche 1 - 6, wobei als zu präparierende Probe eine Probe für die Synchrotron-Tomographie (311) hergestellt wird.

13. Verfahren nach einem der Ansprüche 1 - 12, wobei die zu präparierende Probe durch einen Unterschnitt vom Objekt (301) abgetrennt wird, wobei der Unterschnitt mit dem Laserstrahl oder dem fokussierten Ionenstrahl oder dem Elektronenstrahl ausgeführt wird.

14. Verfahren nach einem der Ansprüche 1 - 6, wobei als zu präparierende Probe (312) eine Probe für die In-situ-Untersuchung mikromechanischer Materialeigenschaften hergestellt wird.

15. Verfahren nach einem der Ansprüche 1 - 14, wobei die präparierte Probe mithilfe eines Mikromanipulators gehandhabt wird.

16. Vorrichtung zur Probenpräparation mittels Lichtpulsen unter Abtrag von Volumen, die größer als 100 µm³ sind, umfassend ein Ionenmikroskop zum Erzeugen eines fokussierten Ionenstrahls (43, FIB) oder ein Rasterelektronenmikroskop und weiterhin umfassend ein Lasersystem zur Laserbearbeitung, und umfassend eine Betriebssoftware, mit der Flächenmarkierungen in ein Bild eines Objekts einblendbar sind, wobei die Vorrichtung konfiguriert ist,
- ein Bild des Objekts (301) aufzunehmen und anhand des Bildes des Objekts einen Laser-Bearbeitungsweg festzulegen, wobei eine erste und eine zweite Flächenmarkierung in das Bild eingefügt werden; und die erste Flächenmarkierung eine Vorstufe der zu präparierenden Probe repräsentiert; und die Fläche der zweiten Flächenmarkierung die Fläche der ersten Flächenmarkierung beinhaltet; und die Fläche der zweiten Flächenmarkierung abzüglich der Fläche der ersten Flächenmarkierung den Bereich definiert, in der der Laserbearbeitungsweg liegt;
- eine Probe aus dem Objekt (301) durch Laserbearbeitung entlang des festgelegten Laser-Bearbeitungswegs heraus zu präparieren und
- anschließend mittels des Rasterelektronenmikroskops (REM) und/oder des fokussierten Ionenstrahls (43) zu inspizieren.

17. Vorrichtung nach Anspruch 16, wobei eine erste Bearbeitungskammer Bestandteil eines Rasterelektronenmikroskops oder Bestandteil eines Ionenmikroskops ist und eine zweite Bearbeitungskammer mit einem Lasersystem zur Laserbearbeitung verbunden ist, und eine Transportvorrichtung (21) vorgesehen ist, mittels der das Objekt (301) von der ersten Bearbeitungskammer in die zweite Bearbeitungskammer transferierbar ist und von der zweiten Bearbeitungskammer in die erste Bearbeitungskammer transferierbar ist.

18. Vorrichtung nach einem der Ansprüche 16 - 17, wobei das Lasersystem (91) zur Laserbearbeitung einen Puls-Laser umfasst.

19. Vorrichtung nach einem der Ansprüche 16 - 18, wobei die Vorrichtung einen Mikromanipulator umfasst.

## Claims

1. Method of sample preparation by means of light pulses while ablating a volume, including the following steps:
- inspecting an object (301) by means of a scanning electron microscope (SEM) or a focussed ion beam (FIB), with an image of the object (301) being recorded,
- setting a region of the object (301) to be examined,
- setting a laser processing path on the basis of the image of the object (301) in such a way that a sample (308, 309, 310, 311, 312) can be prepared from the object (301), wherein a first surface marking (303) and a second surface marking (304) are introduced into the image of the object, wherein the first surface marking (303) represents a preliminary stage of the sample (302) to be prepared; and the area of the second surface marking (304) contains the area of the first surface marking (303); and the area of the second surface marking minus the area of the first surface marking defines the region (305) in which the laser processing path is located;
- removing a volume (307) to be ablated by way of laser processing along the set laser processing path, wherein the volume to be ablated by the light pulses is greater than 100 *µ*m³ and converted into a material cloud, and
- inspecting the object (301) by means of a scanning electron microscope (SEM) or a focussed ion beam (43, FIB).

2. Method according to Claim 1, wherein the ablation is implemented using the laser beam in the case of volumes (307) to be ablated that are greater than or equal to 100 *µ*m³ and the ablation is implemented using a focussed particle beam (41) in the case of volumes (307) to be ablated that are less than 100 *µ*m³.

3. Method according to Claim 1 or 2, wherein the object (301) is not observed during the laser processing.

4. Method according to any one of Claims 1-3, wherein, following the removal of the volume to be ablated, the surfaces of the object (301) that have arisen by the laser processing are post-processed using the focussed ion beam (FIB).

5. Method according to any one of Claims 1-4, wherein the object (301) is transferred from a first processing chamber, which is a constituent part of a scanning electron microscope (SEM) and/or a constituent part of an ion microscope, to a second processing chamber, which is a constituent part of a laser processing system, and subsequently transferred from the second processing chamber into the first processing chamber.

6. Method according to any one of Claims 1-5, wherein the laser processing is carried out using a pulsed laser.

7. Method according to any one of Claims 1-6, wherein a TEM lamella (308) is produced as sample to be prepared.

8. Method according to any one of Claims 1-6, wherein a sample for FIB/SEM tomography (309) is produced as sample to be prepared.

9. Method according to any one of Claims 1-6, wherein a sample for FIB/SEM tomography (309) is produced as sample to prepared and the sample is also used for EDS and/or WDS analysis.

10. Method according to any one of Claims 1-6, wherein a sample for EBSD analysis (310) is produced as sample to be prepared.

11. Method according to any one of Claims 1-6, wherein a sample (311) for high-resolution x-ray tomography using conventional x-ray sources is produced as sample to be prepared.

12. Method according to any one of Claims 1-6, wherein a sample for synchrotron tomography (311) is produced as sample to be prepared.

13. Method according to any one of Claims 1-12, wherein the sample to be prepared is separated from the object (301) by an undercut, wherein the undercut is carried out using the laser beam or the focussed ion beam or the electron beam.

14. Method according to any one of Claims 1-6, wherein a sample for in-situ examination of the micromechanical material properties is produced as sample (312) to be prepared.

15. Method according to any one of Claims 1-14, wherein the prepared sample is handled with the aid of a micromanipulator.

16. Apparatus for sample preparation by means of light pulses while ablating a volume, said samples being larger than 100 *µ*m³, comprising an ion microscope for generating a focussed ion beam (43, FIB) or a scanning electron microscope and furthermore comprising a laser system for laser processing, and comprising an operating software, by means of which surface markings are able to be superimposed into an image of an object, wherein the apparatus is configured
- to record an image of the object (301) and set a laser processing path on the basis of the image of the object, wherein a first and a second surface marking are inserted into the image; and the first surface marking represents a preliminary stage of the sample to be prepared; and the area of the second surface marking contains the area of the first surface marking; and the area of the second surface marking minus the area of the first surface marking defines the region in which the laser processing path is located;
- to prepare a sample from the object (301) by laser processing along the set laser processing path and
- to subsequently inspect said sample by means of the scanning electron microscope (SEM) and/or the focussed ion beam (43).

17. Apparatus according to Claim 16, wherein a first processing chamber is a constituent part of a scanning electron microscope or a constituent part of an ion microscope and a second processing chamber is connected to a laser system for laser processing, and provision is made of a transportation apparatus (21), by means of which the object (301) is transferable from the first processing chamber to the second processing chamber and from the second processing chamber to the first processing chamber.

18. Apparatus according to either of Claims 16-17, wherein the laser system (91) for laser processing comprises a pulsed laser.

19. Apparatus according to any one of Claims 16-18, wherein the apparatus comprises a micromanipulator.

## Revendications

1. Procédé de préparation d'échantillon au moyen d'impulsions lumineuses avec ablation de volume, le procédé comprenant les étapes suivantes :
- inspecter un objet (301) au moyen d'un microscope électronique à balayage (REM) ou d'un faisceau ionique focalisé (FIB), une image de l'objet (301) étant capturée,
- spécifier une région de l'objet (301) à examiner,
- spécifier un chemin de traitement laser à partir de l'image de l'objet (301) de telle sorte qu'un échantillon (308, 309, 310, 311, 312) puisse être préparé à partir de l'objet (301), un premier marquage de surface (303) et un deuxième marquage de surface (304) étant insérés dans l'image de l'objet, le premier marquage de surface (303) représentant un stade préalable de l'échantillon (302) à préparer ; et la surface du deuxième marqueur de surface (304) comprenant la surface du premier marqueur de surface (303) ; et la surface du deuxième marquage de surface moins la surface du premier marquage de surface définissant la région (305) dans laquelle se trouve le chemin de traitement laser ;
- éliminer un volume d'ablation (307) par traitement laser le long du chemin de traitement laser spécifié, le volume d'ablation par les impulsions lumineuses étant supérieur à 100 *µ*m³ et étant converti en un nuage de matière et
- inspecter l'objet (301) à l'aide d'un microscope électronique à balayage (REM) ou d'un faisceau d'ions focalisé (43, FIB).

2. Procédé selon la revendication 1, pour des volumes d'ablation (307) supérieurs ou égaux à 100 *µ*m³, l'ablation étant effectuée avec le faisceau laser, et pour des volumes d'ablation (307) inférieurs à 100 *µ*m³, l'ablation étant effectuée avec un faisceau de particules focalisé (41).

3. Procédé selon la revendication 1 ou 2, l'objet (301) n'étant pas observé lors du traitement laser.

4. Procédé selon l'une des revendications 1 à 3, après l'enlèvement du volume d'ablation, les surfaces de l'objet (301) créées par le traitement laser étant soumises à un traitement ultérieur avec le faisceau d'ions focalisé (FIB).

5. Procédé selon l'une des revendications 1 à 4, l'objet (301) étant transféré d'une première chambre de traitement, qui fait partie d'un microscope électronique à balayage (REM) et/ou d'un microscope ionique, dans une deuxième chambre de traitement qui fait partie d'un système de traitement laser, puis étant transféré de la deuxième chambre de traitement à la première chambre de traitement.

6. Procédé selon l'une des revendications 1 à 5, le traitement laser étant effectué avec un laser à impulsions.

7. Procédé selon l'une des revendications 1 à 6, une lamelle TEM (308) étant produite en tant qu'échantillon à préparer.

8. Procédé selon l'une des revendications 1 à 6, un échantillon destiné à la tomographie FIB/REM (309) étant produit en tant qu'échantillon à préparer.

9. Procédé selon l'une des revendications 1 à 6, un échantillon destiné à la tomographie FIB/REM (309) étant produit en tant qu'échantillon à préparer et l'échantillon étant également utilisé pour une analyse EDS et/ou WDS.

10. Procédé selon l'une des revendications 1 à 6, un échantillon destiné à l'analyse EBSD (310) étant produit comme échantillon à préparer.

11. Procédé selon l'une des revendications 1 à 6, un échantillon (311) destiné à une tomographie à rayons X à haute résolution avec des sources de rayons X classiques étant produit en tant qu'échantillon à préparer.

12. Procédé selon l'une des revendications 1 à 6, un échantillon destiné à la tomographie à synchrotron (311) étant produit en tant qu'échantillon à préparer.

13. Procédé selon l'une des revendications 1 à 12, l'échantillon à préparer étant séparé de l'objet (301) par une contre-dépouille, la contre-dépouille étant réalisée avec le faisceau laser ou le faisceau d'ions focalisé ou le faisceau d'électrons.

14. Procédé selon l'une des revendications 1 à 6, un échantillon destiné à l'examen in situ de propriétés micromécaniques du matériau étant produit en tant qu'échantillon à préparer (312).

15. Procédé selon l'une des revendications 1 à 14, l'échantillon préparé étant manipulé à l'aide d'un micromanipulateur.

16. Dispositif de préparation d'échantillons au moyen d'impulsions lumineuses avec ablation de volumes supérieurs à 100 *µ*m³, le dispositif comprenant un microscope ionique destiné à générer un faisceau ionique focalisé (43, FIB) ou un microscope électronique à balayage et comprenant en outre un système laser destiné au traitement laser, et comprenant un logiciel de traitement permettant d'insérer des marquages de surface dans une image d'un objet, le dispositif étant conçu pour
- capturer une image de l'objet (301) et spécifier une trajectoire de traitement laser sur la base de l'image de l'objet, un premier et un deuxième marquage de surface étant insérés dans l'image ; et le premier marquage de surface représentant un stade préalable de l'échantillon à préparer ; et la surface du deuxième marqueur de surface comprenant la surface du premier marqueur de surface ; et la surface du deuxième marquage de surface moins la surface du premier marquage de surface définissant la surface dans laquelle se trouve le trajet de traitement laser ;
- préparer un échantillon à partir de l'objet (301) par traitement laser le long du chemin de traitement laser défini et
- l'inspecter ensuite au moyen du microscope électronique à balayage (REM) et/ou du faisceau d'ions focalisé (43).

17. Dispositif selon la revendication 16, une première chambre de traitement faisant partie d'un microscope électronique à balayage ou d'un microscope ionique et une deuxième chambre de traitement étant reliée à un système laser destiné au traitement laser, et un dispositif de transport (21) étant prévu qui permet de transférer l'objet (301) de la première chambre de traitement dans la deuxième chambre de traitement et de le transférer de la deuxième chambre de traitement dans la première chambre de traitement.

18. Dispositif selon l'une des revendications 16 et 17, le système laser (91) destiné au traitement laser comprenant un laser à impulsions.

19. Dispositif selon l'une des revendications 16 à 18, le dispositif comprenant un micromanipulateur.
